# EUROPÄISCHE PATENTANMELDUNG

(11) **EP 1 582 828 A1**
(43) Veröffentlichungstag der Anmeldung: **05.10.2005**
(21) Anmeldenummer: 04007637.4
(22) Anmeldetag: 30.03.2004
(51) Int. Cl.: F25B 49/02, H01L 23/34

(54) **Vorrichtung und Verfahren zum Kühlen von einem oder mehreren Halbleiterelementen und/oder laseraktiven Materialien**

(71) Anmelder: KRESS, Ekkehard, 83512 Wasserburg am Inn (DE)
(72) Erfinder: KRESS, Ekkehard, 83512 Wasserburg am Inn (DE)

(57) **Zusammenfassung**

Die Erfindung geht aus von einer Vorrichtung zum Kühlen von einem oder mehreren Halbleiterelementen und/oder laseraktiven Materialien, mit einer Kühlkammer (1), die mit dem Halbleiterelement und/oder dem laseraktiven Material verbunden ist, mit einem Kühlmittelkreislauf, der an die Kühlkammer angeschlossen ist und von einer Pumpe (4) getrieben wird und mit einem Wärmetauscher (9), in dem das von der Kühlkammer kommende Kühlmittel abgekühlt wird. Erfindungsgemäß sind in Förderrichtung zwischen Kühlkammer und Pumpe eine Unterdruckleitung (5) und zwischen der Pumpe und einer Verdampfungskammer eine Überdruckleitung vorgesehen. Über eine Steuereinrichtung sind Ventile und die Pumpe so ansteuerbar, dass an dem Ausgang der Verdampfungskammer ein steuerbarer Unterdruck anliegt.

## Beschreibung

Die Erfindung geht aus von einer Vorrichtung und einem Verfahren zum Kühlen von einem oder mehreren Halbleiterelementen, insbesondere eines Laserdiodenbarren und/oder laseraktiven Materialien, nach dem Oberbegriff von Anspruch 1, bzw. des Oberbegriffs von Anspruch 8.

Aus der DE 19605302 A1 ist es bekannt, einen Kühler über einen geringen thermischen Widerstand direkt mit dem Halbleiter zu verbinden. Die DE 4344227 A1 zeigt eine entsprechende Kühlanordnung für laseraktives Material. Solche Kühler werden dann üblicherweise mit ihrer Wärmesenke in einen Kühlmittelkreislauf eingebunden, der von einer Pumpe getrieben wird. Das Kühlmittel nimmt dabei in der Wärmesenke Wärmeenergie auf und gibt diese in einem Wärmetauscher, der an anderer Stelle in den Kühlmittelkreislauf eingebunden ist, wieder an die Umgebung ab.

Bei Halbleitern bzw. laseraktiven Materialien hoher Leistung entsteht dabei ein Temperaturgefälle zwischen Kühlmedium und Halbleiter bzw. laseraktivem Material in Abhängigkeit von der Verlustleistung des Halbleiters bzw. laseraktivem Materials im Bereich von 10 bis über 30 Kelvin. Wird das Halbleiterbauelement, z. B. ein Diodenlaser-Barren mit hoher Leistung, unter wechselnder Last mit einer Frequenz von etwa einem Hertz betrieben, so entsteht an dem Diodenlaser-Barren ein Temperaturwechsellastprofil mit einem Temperaturhub vom beispielsweise 30 Kelvin über die Zeit betrachtet.

Diese erhebliche Temperaturwechsellast führt mittelfristig zu Mikrorissen in der Verbindung zwischen der Wärmesenke und dem Halbleiter. Dadurch wird aber die thermische Kopplung immer schlechter und es kann immer weniger Wärmeenergie an das Kühlmedium abgegeben werden. Damit steigt die Temperatur an dem Halbleiter immer stärker an. Dies führt letztendlich zur Zerstörung des Elements. Die Standzeit solcher Hochleistungs-Diodenlaser-Barren ist daher mit den bekannten Kühlsystemen nicht sehr hoch. Gleiches gilt bei der Kühlung von laseraktivem Material.

Es war daher die Aufgabe der Erfindung eine Vorrichtung und ein Verfahren zum Kühlen von Halbleiterelementen oder von laseraktivem Material so auszugestalten, dass die Kühlleistung so steuerbar ist, dass der Temperaturwechsel des Halbleiterelements oder des laseraktiven Materials auch bei Wechsellast stark vermindert wird.

Gelöst wird die Aufgabe durch eine Vorrichtung zum Kühlen eines Halbleiterelements und/oder laseraktiven Materials mit den kennzeichnenden Merkmalen von Anspruch 1, bzw. durch ein Verfahren zum Kühlen eines Halbleiterelements und/oder laseraktiven Materials mit den kennzeichnenden Merkmalen von Anspruch 8. Durch den steuerbaren Unterdruck am Ausgang der Verdampfungskammer lässt sich die Kühlleistung des Kühlsystems sehr schnell an die jeweilige Wärmeleistung des Halbleiterelements und/oder des laseraktiven Materials anpassen. Die Steuerung kann so erfolgen, dass im Wechsellastbetrieb des Halbleiterelements und/oder des laseraktiven Materials die Kühlleistung immer dann erhöht wird, wenn eine erhöhte Wärmemenge ab zu transportieren ist und die Kühlleistung dann verringert wird, wenn keine große Abwärme anfällt.

Idealerweise wird die Verdampferfunktion in die Kühlkammer integriert, so dass nur eine einzige Kammer für das Verdampfen des Kühlmittels und die Übertragung der Abwärme des Halbleiterelements und/oder des laseraktiven Materials an das Kühlmittel notwendig ist. Ebenso kann es aber auch notwendig sein mehrere parallele Verdampferkammern zu betreiben.

Der Unterdruck am Ausgang der Kühlkammer wird erfindungsgemäß so dimensioniert, dass das Kühlmittel in der Kühlkammer verdampft. Über die Höhe des Unterdrucks lässt sich nun sehr genau die Verdampfungstemperatur des Kühlmittels beeinflussen. Wird eine hohe Kühlleistung benötigt, muss der Unterdruck so weit erhöht werden, dass das Kühlmedium bereits bei niedriger Temperatur verdampft und der Dampf aufgrund der großen Temperaturdifferenz zwischen Halbleiter und Dampf schnell viel Wärmeenergie aufnehmen kann. In Betriebsphasen mit geringer Verlustleistung des Halbleiterelements und/oder des laseraktiven Materials kann der Unterdruck verringert werden. Entsprechend erhöht sich die Verdampfungstemperatur des Kühlmediums in der Kühlkammer. Der Temperaturunterschied zwischen dem Halbleiter und/oder dem laseraktiven Material und dem Dampf wird dadurch geringer und es wird weniger Wärmeenergie durch das Kühlsystem abgeführt.

Die Steuerung des Unterdrucks in der Kühlkammer kann über die Regelung der Pumpenleistung erfolgen. Diese Steuerung reagiert allerdings verhältnismäßig träge und wird daher nur für eine langsame Anpassung verwendet. Für schnelle Änderungen sind Bypassleitungen zwischen der Überdruckleitung und der Unterdruckleitung vorgesehen. Diese Bypassleitungen können über Steuerventile, je nach Bedarf, geöffnet und geschlossen werden. Durch das Öffnen der Steuerventile lässt sich sehr schnell der Unterdruck in der Kühlkammer verringern und so die Kühlleistung des Kühlsystems vermindern. Zum Erhöhen der Kühlleistung werden die Steuerventile wieder geschlossen und der notwendige Unterdruck wird aufgrund des geringen Volumens von Kühlkammer und Unterdruckleitung sehr schnell wieder erreicht.

Vorteilhafterweise wird der Druck in der Kühlkammer direkt über einen Drucksensor gemessen und von der Steuerung ausgewertet. Auch die Temperatur des Halbleiterelements und/oder des laseraktiven Materials wird überwacht. Auf diese Weise stehen der Steuerung alle Informationen zur Verfügung, damit bei Wechsellast Temperaturschwankungen effektiv gegengesteuert werden kann.

Temperatursensoren vor und hinter dem Wärmetauscher dienen einer Anpassung des Kühlkreislaufs an den Wirkungsgrad des Wärmetauschers. Handelt es sich bei dem Wärme aufnehmenden Medium beispielsweise um Luft, ist der Wirkungsgrad stark von der momentanen Umgebungstemperatur abhängig. Sinkt der Wirkungsgrad, so kann von der Steuerung durch eine Erhöhung des Durchflusses an Kühlmittel gegengesteuert werden, in dem beispielsweise ein Ventil in der Überdruckleitung vor der Kühlkammer weiter geöffnet wird.

Weitere Einzelheiten und Vorteile der Erfindung gehen aus den Unteransprüchen und der Beschreibung eines Ausführungsbeispiels hervor.

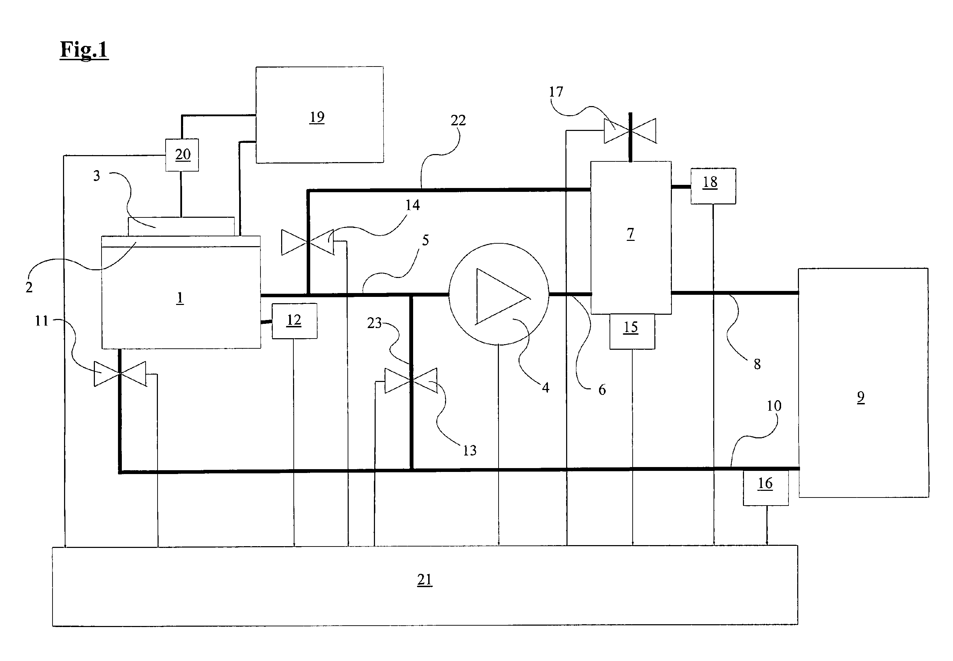

Die einzige Figur zeigt ein Schema eines erfindungsgemäßen Kühlsystems für einen Hochleistungs-Diodenlaser-Barren. Die Erfindung gilt jedoch auch für die Kühlung anderer Leistungs-Halbleiterelemente, die Kühlung von laseraktiven Materialien oder die Kühlung von gemeinsam mit Laserbarren montierten laseraktiven Materialien.

Der Hochleistungs-Diodenlaser-Barren 3 ist über die Wärmesenke 2 gut wärmeleitend mit der Kühlkammer 1 verbunden. Eine andere, noch effektivere Möglichkeit wäre es den Hochleistungs-Diodenlaser-Barren 3 direkt in der Kühlkammer 1 vorzusehen. Hierbei ergibt sich jedoch ein Problem, da das emittierte Licht durch das Kühlmedium in ungewollter Weise beeinflusst werden würde. Um dies zu umgehen, müssten aufwändige Abdichtungen um den Lichtaustritt des Hochleistungs-Diodenlaser-Barren vorgesehen werden. Bei anderen Leistungs-Halbleiterelementen ist diese Ausgestaltung der Erfindung aber ohne weiteres möglich und vorteilhaft.

Mit 19 ist eine Stromquelle bezeichnet, die den Hochleistungs-Diodenlaser-Barren mit Strom versorgt. Der fließende Strom wird über das Amperemeter 20 gemessen und die Messwerte werden an die Steuerung 21 übermittelt.

Die Pumpe 4 ist über die Unterdruckleitung 5 mit der Kühlkammer 1 des Hochleistungs-Diodenlaser-Barren 3 verbunden. Auf der Druckseite der Pumpe 4 stellt die Leitung 6 die Verbindung zu dem Volumenausgleichs- und Entlüftungsbehälter 7 her. Die abgeschiedenen Gase sammeln sich im oberen Teil und können über das Ventil 17 abgelassen werden, welches auch als Überdruckventil fungiert. Der Druck wird über den Drucksensor 18 kontrolliert.

Über die Leitung 8 wird das Kühlmittel in den Wärmetauscher 9 gefördert. Hierbei kann es sich um einen Wasser-Luft-Tauscher handeln, der die Wärme dem Kühlmittel (z. B. Wasser) entzieht und an die Umgebungsluft abgibt.

Die Leitung 10 bildet die Verbindung zwischen dem Wärmetauscher 9 und der Kühlkammer 1. Über das Ventil 11 ist eine Steuerung der Durchflussmenge des Kühlmittels möglich.

Die Temperatursensoren 15 und 16 sind mit der Steuerung 21 verbunden und geben Aufschluss über den Wirkungsgrad des Wärmetauschers.

Es sind noch zwei Bypassleitungen 22 und 23 vorgesehen, die jeweils die Überdruckseite der Pumpe 4 mit der Unterdruckseite verbinden. Der Bypass 22 verbindet über das Ventil 14 den Volumenausgleichs- und Entlüftungsbehälter 7 mit der Unterdruckleitung 5 zwischen Kühlkammer 1 und Pumpe 4. Der Bypass 23 verbindet über das Ventil 13 die Leitung 10 zwischen Wärmetauscher 9 und Kühlkammer 1 ebenfalls mit der Unterdruckleitung 5 zwischen Kühlkammer 1 und Pumpe 4.

Um die Temperatur des Hochleistungs-Diodenlaser-Barren 3 stabil halten zu können, muss die Temperatur überwacht werden. Dies kann direkt über einen Temperatursensor erfolgen, der an der Wärmesenke 2 angebracht ist. So eine Messung ist jedoch verhältnismäßig träge, weil die Temperatur der Wärmesenke 2 und nicht direkt die Temperatur des Hochleistungs-Diodenlaser-Barren 3 gemessen wird. Das bedeutet, dass noch ein Temperaturanstieg gemessen wird, wenn die Leistung des Hochleistungs-Diodenlaser-Barren 3 bereits reduziert wird. Hier kann eine Messung der Stromstärke durch das Amperemeter 20 zu Hilfe genommen werden. Auf diese Weise ist zumindest der Zeitpunkt bekannt, an dem die Leistung reduziert wird. Dies gilt entsprechend umgekehrt bei einer Anhebung der Leistung.

Eine echte Messung der Temperatur des Hochleistungs-Diodenlaser-Barren 3 lässt sich auf optischem Wege vornehmen. Hierzu werden im Strahlengang des Hochleistungs-Diodenlaser-Barren 3 zwei Sensoren vorgesehen, deren Empfindlichkeit in benachbarten Wellenlängenbereichen des emittierten Spektrums liegen. Der Laser reagiert auf eine Temperaturveränderung mit einem Shift der emittierten Wellenlänge. Dieser Shift und damit die Temperatur des Hochleistungs-Diodenlaser-Barren 3 kann mit diesen beiden Sensoren sehr genau ermittelt werden. Der Übersichtlichkeit halber sind die beschriebenen Methoden der Temperaturermittlung in der Zeichnung nicht dargestellt.

Mit dem gezeigten Kühlsystem soll eine möglichst geringe Temperaturdifferenz zwischen aktivem und passivem Zustand des Hochleistungs-Diodenlaser-Barren 3 erreicht werden. Bei einem sehr geringen thermischen Widerstand zwischen Halbleiterelement und Wärmesenke wird ein flüssiges Medium, idealerweise Wasser in einer geregelten Unterdruckkammer, die auch zugleich Kühlkammer bzw Wärmesenke sein kann, verdampft. Zwischen Siedetemperatur des verwendeten Kühlmittels und dem anliegenden Unterdruck besteht ein direkter Zusammenhang. Mit einem geeigneten Verdichter (Kompressor oder Pumpe 4) wird möglichst nahe an der Kühlkammer 1 der entstehende Dampf abgesaugt und über ein Regelsystem der Unterdruck konstant gehalten. Damit bleibt auch die Temperatur in der Kühlkammer 1, unabhängig von der abgegebenen Verlustleistung, weitgehend konstant, da diese Verlustwärme sofort von dem Kühlmittel aufgenommen und abgeführt wird, bevor sie zu einer Temperaturerhöhung führt.

Besitzt die Wärmesenke jedoch einen höheren thermischen Widerstand kann die Verlustwärme nicht sofort abgeführt werden und das Halbleiterelement heizt sich auf, so dass ein größerer Temperaturwechselhub entsteht. Da mit der erfindungsgemäßen Vorrichtung und dem erfindungsgemäßen Verfahren im Gegensatz zu den bekannten Kühlsystemen eine sehr schnelle Temperaturänderung des Kühlmediums über eine Druckänderung möglich ist, kann der Temperaturwechselhub auf nahezu Null gebracht werden. Damit wird eine signifikante Lebensdauersteigerung des Hochleistungs-Diodenlaser-Barren 3 bewirkt. Die Druckänderung kann beispielsweise durch magnetisch oder piezoelektrisch gesteuerte Bypassventile 13, 14 und/oder eine Leistungsänderung der Pumpe 4 erreicht werden.

Der Temperaturhub ΔT entsteht durch den thermischen Widerstand Rₜₕ der Wärmesenke 2 nach der Beziehung: ΔT = Rₜₕ • Pᵥ. Wenn die abzuführende Verlustleistung Pᵥ gleich Null wird, weil der Hochleistungs-Diodenlaser-Barren 3 abgeschaltet ist, geht die Temperaturdifferenz ebenfalls auf Null und der Hochleistungs-Diodenlaser-Barren 3 nimmt schnell die niedrigere Temperatur des Kühlmediums an. Beim Einschalten entsteht wiederum Verlustleistung am Hochleistungs-Diodenlaser-Barren 3 und damit ergibt sich wieder die Temperaturdifferenz zwischen Kühlmedium und Hochleistungs-Diodenlaser-Barren 3. Bei Schaltvorgängen im Sekundenbereich ist dieser Effekt sehr ausgeprägt, nimmt allerdings mit zunehmender Frequenz wegen der Wärmekapazitäten der Wärmesenke 2 und des Hochleistungs-Diodenlaser-Barren 3 ab.

Erfindungsgemäß wird jetzt synchron zum Ein- und Ausschalten des Hochleistungs-Diodenlaser-Barren 3 die Kühltemperatur sehr schnell durch Absenken und Erhöhen des Drucks in der Kühlkammer 1 derart eingestellt, dass die Temperaturdifferenz genauso groß ist wie die abfallende oder ansteigende Temperatur an der Wärmesenke 2 und so dieser Temperaturänderung entgegenwirkt. Somit bleibt die Temperatur im Lastwechselzyklus am Hochleistungs-Diodenlaser-Barren 3 konstant.

Die thermische Wechsellastbeanspruchung ist dadurch sehr gering bzw. praktisch nicht mehr vorhanden. Die Steuerung des Systems erfolgt über eine Mikroprozessorschaltung 21, in der die Systemeigenschaften in Tabellen hinterlegt sind, oder die selbstlernend reagiert.

Im ersten Fall arbeitet die Mikroprozessorschaltung 21 im regeltechnischem Sinne als Steuerung, weil keine Rückkoppelung der Temperatur des Hochleistungs-Diodenlaser-Barren 3 erforderlich ist. In Abhängigkeit des Lastfalls (z. B. Diodenstrom) wird auf eine vorher definierte, z. B. durch Messungen ermittelte, absolute Drucktabelle zugegriffen und dieser Druck in der Kühlkammer 1 mittels der Bypassventile 13, 14 und/oder der Regelung der Leistung der Pumpe 4 eingestellt. Die Bypasskreise 22, 14; 23, 13 wirken direkt in die Pumpenöffnung und sind damit räumlich von der Kühlkammer 1 getrennt so dass sie nicht zusätzlich kühlend auf die Wärmesenke 2 wirken, sondern nur die Pumpe 4 kühlen. Eine weitere, gleichwirkende, aber hier nicht gezeigte Möglichkeit wäre es, über ein Ventil Luft oder ein anderes Gas in den Unterdruckbereich des Kühlsystems einströmen zu lassen.

Wenn die Steuerung 21 selbstlernend ausgelegt ist (adaptives Regelsystem), ist es notwendig die Temperatur des Hochleistungs-Diodenlaser-Barren 3, wie oben beschrieben, zu erfassen. Der adaptive Regelalgorhytmus betrachtet die Temperaturdifferenzen in den verschiedenen Lastfällen und generiert bzw. modifiziert Drucktabellen über die wiederum der Verdampferdruck in der Kühlkammer 1 geregelt wird.

Über die Messung eines der Halbleiterverlustleistung entsprechenden proportionalen Wertes kann die Regelung schnell durchgeführt werden. Bei langsameren Prozessen kann auf diese Synchronisation verzichtet werden. Hier ist es möglich, die Temperaturkonstanz am Hochleistungs-Diodenlaser-Barren 3 über eine Halbleitertemperaturmessung und entsprechende Drucknachregelung zu erreichen. Für diese langsamen Regelvorgänge ist kein Bypassystem notwendig, dies kann über die Regelung des Fördervolumens der Pumpe 4 erreicht werden.

## Patentansprüche

1. Vorrichtung zum Kühlen von einem oder mehreren Halbleiterelementen und/oder laseraktiven Materialien, mit wenigstens einer Kühlkammer, die mit dem Halbleiterelement und/oder dem laseraktiven Material verbunden ist, mit einem Kühlmittelkreislauf, der an die Kühlkammer angeschlossen ist und von einer Pumpe getrieben wird und mit einem Wärmetauscher, in dem das von der Kühlkammer kommende Kühlmittel abgekühlt wird, **dadurch gekennzeichnet, dass** in Förderrichtung zwischen Kühlkammer und Pumpe eine Unterdruckleitung und zwischen der Pumpe und wenigstens einer Verdampfungskammer eine Überdruckleitung vorgesehen ist und dass über eine Steuereinrichtung Ventile und die Pumpe so ansteuerbar sind, dass an dem Ausgang der Verdampfungskammer ein steuerbarer Unterdruck anliegt.

2. Vorrichtung nach Anspruch 1, **dadurch gekennzeichnet, dass** die Kühlkammer auch die Verdampfungskammer ist.

3. Vorrichtung nach Anspruch 2, **dadurch gekennzeichnet, dass** der Unterdruck am Ausgang der Kühlkammer so steuerbar ist, dass das Kühlmittel in der Kühlkammer verdampft.

4. Vorrichtung nach Anspruch 3, **dadurch gekennzeichnet, dass** wenigstens eine Bypass-Leitung mit einem Steuerventil zwischen Überdruckleitung und Unterdruckleitung vorgesehen ist.

5. Vorrichtung nach Anspruch 3, **dadurch gekennzeichnet, dass** ein Drucksensor zur Messung des Kühlkammerdrucks vorgesehen ist.

6. Vorrichtung nach Anspruch 1, **dadurch gekennzeichnet, dass** vor dem Wärmestauscher ein Temperatursensor vorgesehen ist.

7. Vorrichtung nach Anspruch 1, **dadurch gekennzeichnet, dass** hinter dem Wärmetauscher ein Temperatursensor vorgesehen ist.

8. Verfahren zum Kühlen von einem oder mehreren Halbleiterelementen und/oder laseraktiven Materialien, mit wenigstens einer Kühlkammer, die mit dem Halbleiterelement und/oder laseraktivem Material verbunden ist, wobei die Verlustwärme des Halbleiterelements und/oder laseraktiven Materials über einen Kühlmittelkreislauf mit einem Wärmetauscher abgeführt wird, **dadurch gekennzeichnet, dass** das Kühlmittel in oder vor der Kühlkammer verdampft wird.

9. Verfahren nach Anspruch 8, **dadurch gekennzeichnet, dass** die Verdampfungstemperatur des Kühlmittels in der Kühlkammer über den am Ausgang der Kühlkammer anliegenden Unterdruck gesteuert wird.

10. Verfahren nach Anspruch 8, **dadurch gekennzeichnet, dass** die Temperatur des Halbleiterelements und/oder laseraktiven Materials überwacht wird.

11. Verfahren nach den Ansprüchen 9 und 10, **dadurch gekennzeichnet, dass** die Verdampfungstemperatur des Kühlmittels in der Kühlkammer so gesteuert wird, dass die Temperatur des Halbleiterelements und/oder laseraktiven Materials annähernd konstant bleibt.

12. Verfahren nach Anspruch 11, **dadurch gekennzeichnet, dass** die Verdampfungstemperatur des Kühlmittels mit der Frequenz des Lastwechsels des Halbleiterelements und/oder laseraktiven Materials der Temperaturänderung des Halbleiterelements und/oder laseraktiven Materials gegengesteuert wird.

## Geänderte Patentansprüche

### Geänderte Patentansprüche gemäss Regel 86(2) EPÜ.

**1.** Verfahren zum Kühlen von einem oder mehreren Halbleiterelementen und/oder laseraktiven Materialien, mit wenigstens einer Kühlkammer, die mit dem Halbleiterelement und/oder laseraktivem Material verbunden ist, wobei die Verlustwärme des Halbleiterelements und/oder laseraktiven Materials über einen Kühlmittelkreislauf mit einem Wärmetauscher abgefürt wird, **dadurch gekennzeichnet, dass** das Kühlmittel in oder vor der Kühlkammer verdampft und die Verdampfungstemperatur des Kühlmittels in der Kühlkammer über den am Ausgang der Kühlkammer anliegenden Unterdruck gesteuert wird.
